# EUROPEAN PATENT APPLICATION

(11) **EP 2 498 062 A2**
(43) Date of publication of application: **12.09.2012**
(21) Application number: 12158537.6
(22) Date of filing: 08.03.2012
(51) Int. Cl.: G01D 4/00

(54) **System and Method for Communicating Device Specific Data Over an Advanced Metering Infrastructure (AMI) Network**

(30) Priority: 11.03.2011 US 201113045716
(71) Applicant: General Electric Company, Schenectady, NY 12345 (US)
(72) Inventor: Parwal, Nawal Kishor, Atlanta, GA 30339-8402 (US)
(74) Representative: Picker, Madeline Margaret

(57) **Abstract**

A system (100) for communicating device specific data over a network includes a smart power device (102) that includes a meter (116), a controller (122) and an advanced metering (116) infrastructure (AMI) network connection coupled to the meter (116) and the controller (122). The system (100) also includes an AMI terminator device (110) configured to receive information from a virtual device server (140) and provide it according to an AMI communication protocol (120) to the AMI network (114) connection via an AMI network (114), the AMI terminator device (110) is further configured to receive information from the meter (116) via the AMI network (114) connection and provide it to a utility (104).

## Description

### BACKGROUND OF THE INVENTION

The subject matter disclosed herein relates to communication and, in particular, to communicating multiple types of information over an AMI network.

A smart grid delivers electricity from suppliers to consumers and includes technology that provides for communications to control appliances or other devices (smart devices) at user's location. Such a system can, possibly, save energy, reduce costs and increase reliability and transparency. The smart grid is made possible by providing for at least one-way (and possibly two-way) communication from the smart power devices to the energy supplier.

One example of a smart power device is a power generator (such as a diesel generator). Another example, of a smart power device is a power consumer (such as an electric vehicle power supply). Of course, smart power devices can simply be a meter or can be any type of appliance that has a meter. Regardless of the type, the smart device typically utilizes a so-called AMI (advanced metering infrastructure) network that is dedicated to communicate (power) meter information to the energy supplier. Such networks typically utilize specifications like ANSI 12.18 on a wireless network such as a radio frequency (RF) mesh or cellular public network. The data sent over these networks is typically limited to simple information such as pricing, time or use, power consumption, and power generation. Such information is typically provided to an energy supplier such as a power plant. The computing device that receives such information may be referred to herein as a "head-end device" in some instances.

It may be desirable to provide the information provided to the head-end of the AMI network (as well as other information) to another device. In such instances, the information may be provided over a different network. For example, rather than the AMI, the information can be provided to a user's computing device (e.g., desk or laptop computer or handheld computing device) via the Internet or over a wide area network (WAN), a home area network (HAN) or an internet protocol (IP) enabled cellular network. As is apparent, providing such additional capabilities requires that the smart power device be able to connect to and communicate over two different types of networks. To do so, the smart power device must include two different input/output devices, one for each type of communication network. Of course, having two different input/output devices increases costs. In addition, depending on the application, an additional web server may need to be provided that is dedicated to the information not provided over the AMI.

### BRIEF DESCRIPTION OF THE INVENTION

According to one aspect of the invention, a system for communicating device specific data over an AMI network is disclosed. The system of this aspect includes a smart power device including a meter, a controller and an advanced metering infrastructure (AMI) network connection coupled to the meter and the controller. The system of this aspect also includes an AMI terminator device configured to receive information from a virtual device server and provide it according to an AMI communication protocol to the AMI network connection via an AMI network, the AMI terminator device is further configured to receive information from the meter via the AMI network connection and provide it to a utility.

According to another aspect of the invention, a method for communicating device specific data over an AMI network is disclosed. The method of this aspect includes: receiving a request to access a smart power device at a virtual device server; converting the request into an advanced metering infrastructure (AMI) format; providing the converted request to an AMI terminator device that is in operative communication with the smart power device via an AMI network; inserting the converted request into the AMI network; receiving the converted request at an AMI communication module in the smart power device; and providing the converted) request to a controller of the smart power device.

These and other advantages and features will become more apparent from the following description taken in conjunction with the drawings.

### BRIEF DESCRIPTION OF THE DRAWING

The subject matter, which is regarded as the invention, is particularly pointed out and distinctly claimed in the claims at the conclusion of the specification. The foregoing and other features, and advantages of the invention are apparent from the following detailed description taken in conjunction with the accompanying drawings in which:
FIG. 1 is an illustrative system according to one embodiment of the present invention; and
FIG 2 is a flow diagram of a method according to one embodiment of the present invention.

The detailed description explains embodiments of the invention, together with advantages and features, by way of example with reference to the drawings.

### DETAILED DESCRIPTION OF EMBODIMENTS OF THE INVENTION

As the technology related to smart power devices increases, the information they can provide is rapidly increasing. For example, smart power devices may be able to provide status or other information above and beyond the usual smart grid power management (consumption and pricing) data. Furthermore, as disclosed below, it can be beneficial to provide this information to a user over a public IP network in a secured manner.

In more detail, at present, smart devices are connected via HAN/Cellular/AMI networks to the head-end computing device (also referred to as an "AMI terminator device" herein) of a utility or other power producer. Such networks and head-end devices were designed with a simple power related dataset in mind. Smart device status and possible control over the AMI network (other than the load control) was not considered.

Embodiments disclosed herein are directed to systems and methods that allow an AMI network (or other existing network) to transport additional data through them. Indeed, embodiments of the present invention may have the technical effect of enabling smart device specific status/control data to be securely published over the AMI network while avoiding the requirement that the device be able to connect to multiple networks (e.g., an AMI network for metering data and other networks for device status and control signals). That is, in one embodiment, the smart device includes communication devices that operate only in a single format. In a specific example, the smart device does not include a communication device that allows it to directly communicate with an additional network.

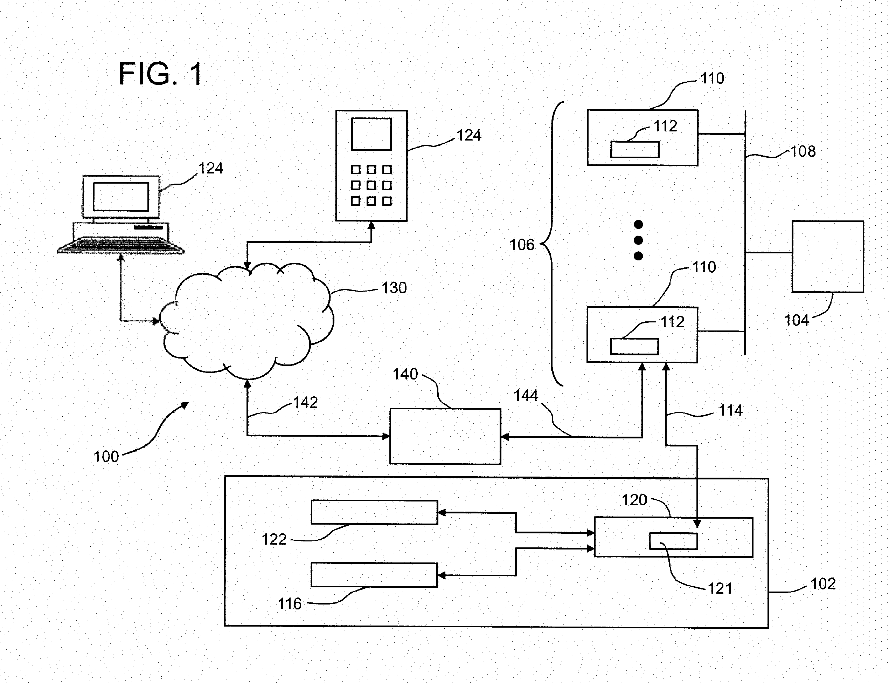

FIG. 1 illustrates a system 100 according to one embodiment of the present invention. It shall be understood that embodiments of the present invention are directed to any of: the system 100 as a whole; individual elements of the system 100; or any combination of the elements of the system 100.

The system 100 includes a smart power device 102. The smart power device 102 can be any type of device that can provide a meter reading to another device or location. Examples include, but are not limited to, home and office appliances, power generators (such as a diesel generator), power consumers (such as an electric vehicle power supply) and the like. In one embodiment, the smart power device 102 is a power meter at a user's home.

The system 100 also includes a utility 104. The utility 104 is a power utility in one environment and provides power to the smart power device 102 over a power grid (not shown) in one embodiment. The utility 104 is coupled to and supports and a head-end system 106. The head-end system 106 includes one or more AMI terminator devices 110 coupled to the utility 104 via a common bus 108. Of course, in one embodiment, the bus 108 could be omitted.

The AMI terminator device 110 receives information from the smart device 102 over an AMI network 114. The AMI network connection 114 can be any existing or later created AMI network connection and may operate on any number of different frequencies and protocols depending on the context. Typically, the AMI network 114 utilizes the ANSI 12.18 specification for powerline networking or radio frequency (RF) networking using standards/methods such as RF- Mesh, ZigBee, INSTEON, Zwave, WiFi or others. The ANSI 12.18 specification is a communication specification used for power meter communication.

According to an embodiment of the present invention, the smart power device 102 includes a meter 116. Such a meter 116 is configured to measure power or another electrical value that is used by the smart power device 102. Of course, in one embodiment, the meter 116 could measure power or another electrical value that is created by the smart power device 102 in the event that the smart power device 102 can produce power (e.g., a mobile diesel generator).

The smart power device 102 also includes an AMI communication module 120. The AMI communication module 120 is configured to provide AMI data from the meter 116 to the AMI terminator device 110 over the AMI network 114. Typically, the data sent over the AMI network 114 is fairly limited and does not provide for status data and control of the smart power device 102.

As described above, in the prior art if it was required that the functionality of a smart power device be accessed over another communication module (e.g., WAN card for connection to an IP enabled cellular network) must be installed in the smart power device. While effective for providing information to and from the controller of the smart power device, such a solution increases costs and requires that the smart power device 102 be able to connect to two different networks.

According to embodiments of the present invention, the system 100 includes mechanisms for allowing the smart power device 102 to connect to both the AMI terminator device 110 and to one or more computing devices 124 coupled to a public communication network 130 (e.g., the Internet). It shall be understood that the computing devices 124 can be any device capable of connecting to a public communication network 130 and can include, as illustrated, hand-held computing devices and general computing devices.

According to one embodiment of the present invention, the system 100 includes a virtual device server 140. The virtual device server 140 is coupled to the AMI terminator device 110 and to the public communication network 130. In particular, the virtual device server 140 is coupled to the public communication network 130 via an IP connection 142. The virtual device server 140 is coupled to the AMI terminator device 110 via a device data line 144. The device data line 144 communicates compressed data between the AMI terminator device 110 and the virtual device server 140 in one embodiment and can be a physical link, a wireless link, or a combination of physical and wireless links.

According to one embodiment, the AMI terminator device 110 includes a head-end data injector/separator module 112. The head-end data injector/separator module 112 is configured to inject data received from the virtual device server 140 into the AMI network 114. In one embodiment, the injected data includes an indication that it is data to be provided to the controller 122. The head-end data injector/separator module 112 is further configured to separate information that is to be provided to the virtual device server 140 from other information received on the AMI network 114.

Likewise, according to one embodiment, the smart power device 102 further includes a smart power device data injector/separator module 121. The smart power device data injector/separator module 121 is configured to separate the data from the virtual device server 140 that was injected into the AMI network 114 by the head-end device data injector/separator module 112. This data includes an indication that it is data to be provided to the controller 122. The smart power device data injector/separator module 121 is further configured to inject into the AMI network 114 information from the controller 122 that is to be provided to the virtual device server 140.

An example of the operation of the system 100 is instructive. In one embodiment, a user (not shown) utilizes one of the computing devices 124 to access the public communication network 130. Utilizing a browser on the computing device, the user can access the URI or other designator for the virtual device server 140 that is related to the smart power device 102. In one embodiment, the virtual device server 140 authenticates the user and accesses the required AMI terminator device 110 that is in communication over the AMI network 114 with the smart power device 102 that the user is interested in communicating with.

In one embodiment, the virtual device server 140 transforms the request for the smart power device 102 and sends it to the AMI terminator device 110. Transforming can include, but neither requires nor is not limited to, reformatting, obfuscating, digitally certifying, encrypting and compressing the request. Utilizing the head-end device data injector/separator module 112, the AMI terminator device 110 sends the request to the smart power device 102 over the AMI network 114.

Upon receipt by the smart power device 102, the smart power device data injector/separator module 121 separates out the request and provides it to the controller 122. It is assumed that the request includes an identifier recognizable by the smart power device data injector/separator module 121 (e.g., a flag) to identify it as being directed to the controller 122. In one embodiment, the meter 116 can provide information to the controller 122 and, in this manner, a request to the controller 122 can be for a reading of the meter 116. In another embodiment, the request can be directed to retrieving information other than a meter reading or can include a command to be performed by the controller 122.

In response to the request, the controller 122 may respond back to the user. Such a response is provided to the smart power device data injector/separator module 121 where the response is embedded into an AMI message provided to the AMI terminator device 110. The head-end data injector/separator module 112 in the AMI terminator device 110 separates the response out and provides it over the device data line 144 to the virtual device server 140. In one embodiment, the virtual device server 140 transforms the data and sends the response back to computing device 124 being utilized by the requesting user through the public communications network 130.

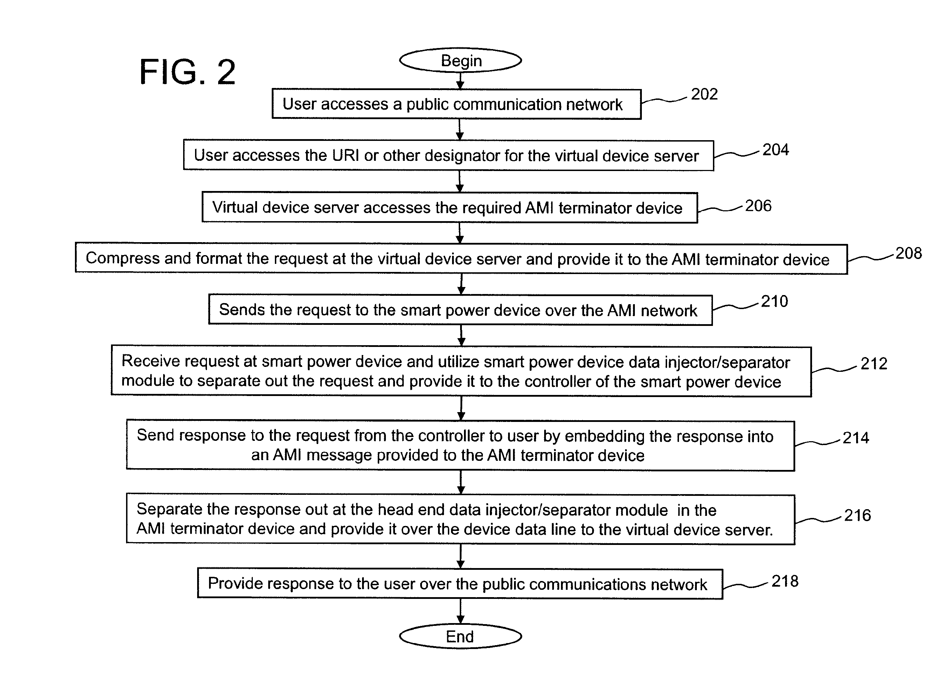

FIG. 2 illustrates a method according to an embodiment of the present invention. It shall be understood that embodiments of the present invention may include all or only some of the steps illustrated in FIG. 2.

The method illustrated in FIG. 2 begins at block 202 where a user accesses a public communication network. The user can utilize any type of computing device to access the network. At block 204, the user accesses the URI or other designator for the virtual device server that is related to the smart power device of interest to the user. In one embodiment, accessing includes authenticating the user. Furthermore, it shall be appreciated that the communication between the user and the virtual device server can be encrypted or otherwise secured in one embodiment.

At block 206, the virtual device server accesses the required AMI terminator device that communicates, over the AMI network, with the power device of interest. At block 208, the virtual device server transforms compresses and formats the request into the correct standard and provides it to the AMI terminator device. Of course, in one embodiment, the request does not need to be transformed. At block 210 the AMI terminator device sends the request to the smart power device over the AMI network.

Upon receipt by the smart power device, at block 212 the smart power device data injector/separator module separates out the request, transforms it and provides it to the controller of the smart power device. At block 214, and in response to the request, the controller may respond back to the user. Providing such a response can include, in one embodiment, embedding the response into an AMI message provided to the AMI terminator device. At block 216 the head-end data injector/separator module in the AMI terminator device separates the response out, transforms it and provides it over the device data link to the virtual device server. At block 218 the response is provided to the user over the public communications network.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

## Claims

1. A system (100) for communicating device specific data over a network comprising:
a smart power device (102) including a meter (116), a controller and an advanced metering infrastructure (AMI) network connection coupled to the meter (116) and the controller (122);
an AMI terminator device (110) configured to receive information from a virtual device server (140) and provide it according to an AMI communication protocol to the AMI network (114) connection via an AMI network (114), the AMI terminator device (110) further configured to receive information from the meter (116) via the AMI network (114) connection and provide it to a utility (104).

2. The system (100) of claim 1, wherein the AMI terminator device (110) includes a head-end data injector/separator module (112) configured to receive the information from the meter (116) and information from the controller (122) through the AMI network (114), the head-end data injector/separator module (112) further configured to separate information received from the controller (122) from information received from the meter (116).

3. The system (100) of claim 2, wherein the head-end data injector/separator module causes information received from the controller (122) to be provided to the virtual device server (140) and information received from the meter (116) to be provided to the utility (104).

4. The system (100) of claim 3, further comprising:
the utility (104); and
a bus coupling the utility (104) to the AMI terminator device (110).

5. The system (100) of claim 3, further comprising:
the virtual server device (140).

6. The system (100) of claim 5, wherein the virtual server device (140) is coupled to a public communications network (130).

7. The system (100) of claim 6, wherein the information from the virtual device server (140) is created based on a request received from a computing device coupled to the public communications network (130).

8. The system (100) of claim 7, wherein the virtual server device (140) is configured to convert the request into the AMI communication protocol.

9. The system (100) of claim 1, further comprising:
a public communications network (130); and
a computing device (124) coupled to the public communications network (130);
wherein the virtual device server (140) is coupled to the public communications network (130) and the information from a virtual device server (140) is based on a request received from the computing device (124) via the public communications network (130).

10. The system (100) of claim 9, wherein the computing device (124) is a hand-held device.

11. The system of any one of claims 1 to 10, wherein the smart power device (102) does not include an adapter that allows it to connect to a public communications network.

12. A method for communicating device specific data over a network, the method comprising:
receiving a request to access a smart power device (102) at a virtual device server (140);
converting the request into an advanced metering infrastructure (AMI) format;
providing the converted request to an AMI terminator device (110) that is in operative communication with the smart power device (102) via an AMI network (114);
inserting the converted request into the AMI network (114);
receiving the converted request at an AMI communication module (120) in the smart power device (120); and
providing the converted request to a controller (122) of the smart power device (102).

13. The method of claim 12, wherein the request is encrypted and is received over a public communications network (130).

14. The method of claim 12 or claim 13, further comprising:
providing a response to the request from the controller (122) to the AMI communication module (120);
providing the response over the AMI network (114) to the AMI terminator device (110);
determining that the response is from the controller (122); and
providing the response to the virtual device server (140).

15. The method of claim 12, 13 or 14, wherein converting the request includes one or more of reformatting, obfuscating, digitally certifying, encrypting or compressing the request.
